(19) Europäisches Patentamt / European Patent Office / Office européen des brevets

(11) **EP 1 635 474 B1**

(12) **EUROPEAN PATENT SPECIFICATION**

(45) Date of publication and mention
of the grant of the patent:
**06.10.2010 Bulletin 2010/40**

(51) Int Cl.:
***H03M 13/27*** *(2006.01)*

(21) Application number: **05110959.3**

(22) Date of filing: **26.01.1996**

(54) **Data transmission with interleaving through in-place addressing of RAM memory**

Datenübertragung mit Verschachtelung durch in-place Addressierung eines RAM Speichers

Transmission de données avec entrelacement par addressage en place d'une mémoire RAM

(84) Designated Contracting States:
**DE DK GB IT NL SE**

(30) Priority: **01.02.1995 EP 95200242**

(43) Date of publication of application:
**15.03.2006 Bulletin 2006/11**

(62) Document number(s) of the earlier application(s) in
accordance with Art. 76 EPC:
**02075867.8 / 1 239 596**
**96900404.3 / 0 760 182**

(73) Proprietor: **Sony Corporation**
**Tokyo 108-0075 (JP)**

(72) Inventor: **Baggen, Constant, P., M., J.**
**5600 AE Eindhoven (NL)**

(74) Representative: **DeVile, Jonathan Mark et al**
**D Young & Co LLP**
**120 Holborn**
**London EC1N 2DY (GB)**

(56) References cited:
**EP-A- 0 370 444**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a method of transmission and reception of data, a transmission system for the transmission and reception of data, a transmitting section and receiving section for such a system.

A method and system of this kind is known from the book "Error correction coding for digital communications" by G.C. Clark and J.B. Cain, Plenum Press New York, 1981, sections 8.5 and 8.3.2.

The cited book describes a system which is intended to counteract jamming. This is achieved by a spread spectrum technique, which involves greatly expanding the transmit spectrum relative to the data rate. The idea is that this forces the jammer to deploy his power over a much wider bandwidth than would be necessary for an unspread spectrum.

The anti-jamming system modulates the information successively at different frequencies. As a function of time, the frequency "hops" from one frequency channel to another. To protect against jammed channels the information is encoded in an error correction code prior to modulation. In addition, the encoded information is interleaved: the time sequential order in which the data-items are modulated is permuted with respect to the order in which they succeed each other in the error protection code. In the prior art technique, interleaving serves to make the anti-jamming system more robust against pulses that jam all frequency channels for part of the time.

The described system makes very inefficient use of the frequencies available. This forces the jammer to deploy his power over a much wider bandwidth and is therefore essential for anti-jamming as described in the book by G.C. Clark and J.B. Cain.

It is inter alia an object of the invention to apply pseudo random interleaving to applications which make more efficient use of the frequencies available.

It is a further object of the invention to provide for multichannel broadcasting which is robust against degradation due to multipath transmission and which makes efficient use of the frequencies available.

The invention provides for a method of transmission and reception of data, the method comprising:

- a transmitting step comprising transmitting data-items that are encoded according to a convolution error correcting code and subsequently pseudo-random interleaved, the data-items being transmitted modulated in a number of simultaneously active frequency channels;
- a receiving step comprising receiving, de-interleaving and decoding the transmitted data-items according to the convolution error correcting code,

characterized in that the de-interleaving comprises writing the received data-items into locations in a memory in an order of writing, and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function, the data-items being interleaved so as to provide an inverse of the de-interleaving. As a result of the simultaneous transmission of information in a number of frequency channels, the frequencies available are efficiently used. The invention addresses the problem of transmission channels that may suffer from multipath transmission rather than from jamming. In the case of wireless broadcasting, for example indirect transmission may occur in addition to direct transmission of electromagnetic radiation, for example due to reflection of the radiation by a building. It has been found that this often leads to variations in the receivability of the various frequency channels. Moreover, it has been found that this variation is often periodic, i.e. it recurs as a function of the frequency after a number of channels. The recurrent period is dependent on the receiving conditions and, generally speaking, it cannot be predicted.

The use of pseudo-random interleaving prevents multipath transmission from causing burst errors that are so long that they cannot be corrected.

Thus, interleaving is performed by writing data items into a memory and by subsequently reading the data items therefrom in a different order. New data is then written into memory locations vacated by reading before all other locations have been read, which makes it possible to save memory space. For monotonously ascending address series this is known per se from US 5,151,976. Moreover, document EP370444 discloses an interleaving method in which symbols to be interleaved are written into an interleaving memory at an address at which interleaved symbols have just been read-out from the interleaving memory following a pseudo-random read/write address sequence. The invention, however, applies this operation to the writing according to a pseudo- random sequence. Despite the fact that such a pseudo-random sequence is far more complex than a monotonous series, it has been found that notably the use of direct writing after reading with random sequences can be used for interleaving.

In the method of the invention the memory addresses are selected alternately as a monotonously ascending or descending order and as the pseudo random function of that order. By using only two different series of addresses in an alternating fashion, interleaving is simplified.

In an embodiment of the invention, the addresses are calculated according to a linear congruential sequence satisfying

$$X_{n+1} = (\, a\, X_n + c\, )\bmod M$$

n being the position of a particular data-item in the second order, $X_n$ being the address from which that particular data-item is read, M being the number of selectable memory locations a and c being a factor and a summand for a linear congruential sequence respectively, the combination of the factor and the summand used being changed for each version of the bas cycle. The factor a and summand c for linear congruential sequences are such that c is a relative prime with respect to M, a-1 is a multiple of all primes factors of M, and a-1 is a multiple of 4 if m is a multiple of 4. This provides for a simple way of generating the addresses. In particular it has been found that, when all "a" used for different versions are such that the square of (a-1) is divisible by M, it is ensured that all orders of addresses which are successively required to read data-item that have been written in the order of locations in which the preceding data-items have been read, can always be generated in correspondence with this formula.

The invention also related to a method of receiving data, and to a system for applying the method and its components, to which similar measures can be applied mutatis mutandis to obtain similar advantages.

These and other aspects of the invention will be apparent from and elucidated with reference to the embodiments described hereinafter.

In the drawings:

Fig. 1 shows a transmission system;
Fig. 2 shows an embodiment of an interleaver;
Fig. 3 shows a further embodiment of an interleaver; and
Fig. 4 shows an embodiment of an address generator.
Fig. 5 shows an embodiment of the transmitting section according to the invention

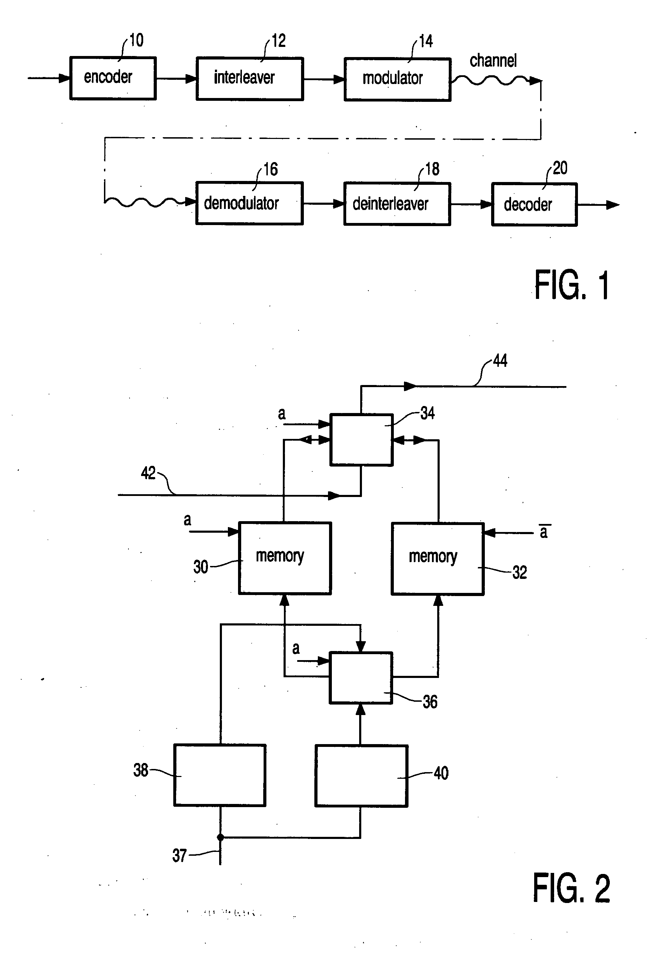

Fig. 1 shows a transmission system. It comprises a cascade connection of successively an encoder 10, an interleaver 12, a modulator 14, a transmission channel, a demodulator 16, a de-interleaver 18 and a decoder 20.

During use data is presented to an input of the encoder 10. The encoder 10 encodes this data in an error correction code. Any known error correction code, for example a convolution code, can be used for this purpose. The encoded data is composed of, for example blocks, each of which contains a logic succession of bits.

The decoder 20 corresponds to the encoder 10 and corrects bit errors incurred during transmission from the encoder 10 to the decoder 20. The error correction code is such that bit errors which occur distributed throughout the logic succession can be readily corrected. Burst errors, where a number of successive bits in the logic succession are incorrect, can be less readily corrected when they are too long.

The modulator 14 produces a signal with a number of frequency channels which are simultaneously transmitted. The bits of each block are distributed among a number of groups. Each group corresponds to a frequency channel and the information of the bits in a group is transmitted in the corresponding frequency channel. This can be realised, for example by interpreting the bits of each group as a number, by arranging these numbers in a series and making an FFT (fast Fourier transform) of the series. The result of the FFT is subsequently transmitted via the transmission channel, for example a wireless terrestrial broadcast channel. FFT and transmission are repeated for successive blocks. This corresponds to the known OFDM (orthogonal frequency division multiplexing) technique.

The demodulator 16 corresponds to the modulator 14. The demodulator receives the various frequency channels simultaneously and reconstructs the groups of bits transmitted in a respective frequency channel. According to the OFDM technique, this is performed, for example by making an inverse FFT of the signal received and by reconstructing the numbers and hence the groups therefrom.

The interleaver 12 serves to ensure that bits which are directly adjacent in the logic succession are substantially always modulated in different frequency channels. The spacing of these channels (in terms of channels with intermediate frequencies) is preferably larger than zero, so that adjacent bits will enter non-adjacent channels. This serves to ensure that a disturbance of a single channel, or of a number of neighbouring channels, does not lead to burst errors in the logic succession.

The de-interleaver 18 corresponds to the interleaver 12 and performs the reverse operation, so that the logic succession is reconstructed in terms of order (i.e. except for bit errors) before being presented to the decoder 20.

The interleaver 12 places every adjacent pair of bits, which succeed one another in the logic succession, at a respective distance, amounting to a number of channels, from one another. The respective distances have different values and it is ensured that the various distances occur approximately equally frequently. As a result, the system is robust to disturbances of the transmission channel which lead to poor reception in a periodic system of frequency channels (in this context a periodic system is to be understood to mean a system in which the poor reception recurs as a function of the frequency each time after the same number of channels).

All other pairs of bits which are so near to one another that a simultaneous error in the bits of such a pair could give rise to burst problems are also placed at a respective distance of a number of channels from one another. These respective distances preferably also have different values and it is ensured that these different distances occur approximately equally frequently.

Fig. 2 shows an embodiment of an interleaver; this device is also suitable as a de-interleaver. The interleaver of Fig. 2 comprises a data input 42 which is coupled, via a multiplexer 34, to respective data inputs/outputs of a first and a second memory 30, 32. The data inputs/outputs of the memories 30, 32 are also coupled, via the multiplexer 34, to an output 44 of the interleaver.

The interleaver also comprises a clock input 37, coupled to clock inputs of a first and a second address generator 38, 40. The output of each of the address generators is coupled to a further multiplexer 36. The outputs of the further multiplexer 36 are coupled to a respective address input of the first and the second memory 38, 40.

During operation the interleaver is switched to and fro between two modes. In a first mode the multiplexer 34 couples the input 42 to the data input of the first memory 30 and the output 44 to the data output of the second memory 32. Furthermore, the further multiplexer 36 couples the output of the first address generator to the address input of the first memory 30 and the output of the second address generator 40 to the address input of the second memory 32. In the second mode the roles of the first and the second memory 30, 32 are reversed in comparison with the first mode.

The first address generator 38 generates a clocked first series of addresses. The various data items presented to the input 42 during successive clock cycles are written at these addresses. Data is read from the second memory 32 in a similar manner, addressed by a second series of addresses from the second address generator, and applied to the output 44. The first and the second series of addresses deviate from one another, resulting in interleaving.

The first series of addresses is, for example a monotonously ascending series (1, 2, 3 ...) and the second series of addresses is a pseudo-random series, for example a series in which a respective difference exists between each pair of directly successively generated addresses; these respective differences have various values and it is ensured that the various values occur approximately equally frequently. The differences correspond to the distances between the frequency channels in which successive bits of the logic succession are arranged.

The corresponding de-interleaver has the same structure as shown in Fig. 2, it that the first address generator of the de-interleaver generates the same address series as second address generator of the interleaver and vice versa.

The pseudo-random series can be generated by assembling the address generator 40 from a counter and a ROM, successive pseudo-random addresses being stored in successive locations in the ROM. Alternatively, use can be made of a known linear congruent series, the addresses $X_n$ for the memory 32 being obtained by way of the recursion relation

$$X_{n+1} = ( a X_n + c ) \bmod M$$

These addresses can be obtained by multiplication and addition, without utilizing a ROM. A further alternative consists in the use of an LFSR (Linear Feedback Shift Register).

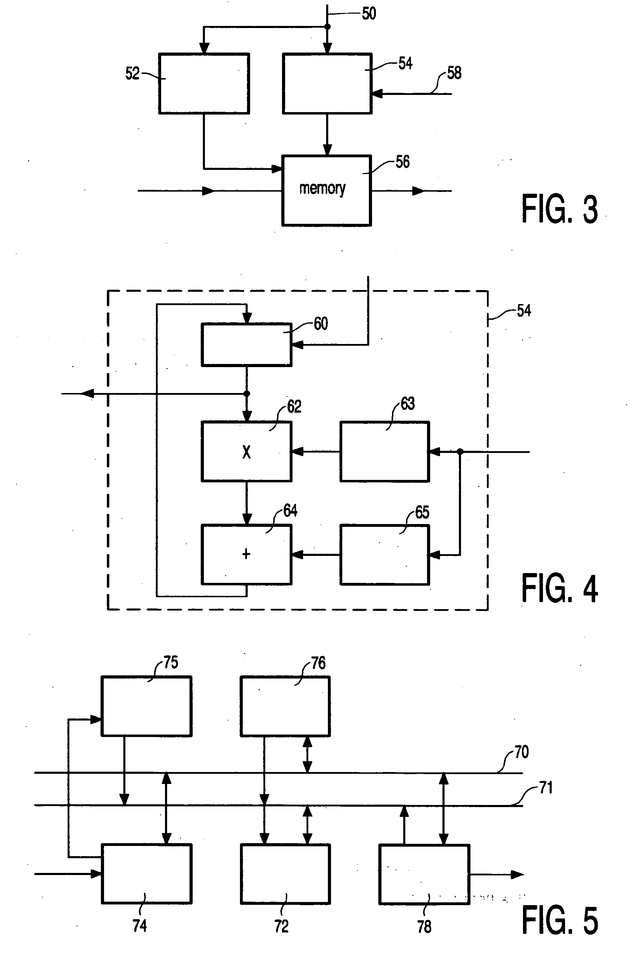

Fig. 3 shows a further embodiment of an interleaver. This embodiment comprises only one memory 56. The input and the output of the interleaver are coupled to a data input and a data output, respectively, of this memory 56. The interleaver also comprises a clock input 50 which is coupled to an address generator 54. An output of the address generator 54 is coupled to an address input of the memory 56. The clock input 50 is also coupled, via a read/write control unit 52, to a read/write control input of the memory.

The address generator 54 generates a series of addresses during operation. For each address a first data item is read from the memory 56 so as to be applied to the output; subsequently, the read/write control circuit switches the memory to the write mode and a data item originating from the input is written into the memory at the same address.

The address generator 54 each time generates such a series of addresses. Each series contains substantially the same addresses. The order in which the addresses succeed one another in directly successive series, however, differs each time. For example, alternately a pseudo-random series $(X_1, X_2, X_3 ... X_n)$ and a normal monotonously ascending series (1, 2, 3 ... N) can be taken. This results in interleaving with a substantially uniform distribution of the differences between successive addresses.

By using only two different series of addresses in an alternating fashion, de-interleaving is simplified (same two series, so that each time the data items are written in the de-interleaver in memory locations which correspond to the locations wherefrom they have been read in the interleaver). However, this approach has the drawback that the method of interleaving is often repeated, so that the transmission system becomes susceptible to systematic disturbances.

Therefore, as an attractive alternative it is possible to use more than two different series and to repeat the pattern of series of addresses used only after more than two complete series. To this end, for broadcast applications a linear congruential sequence is preferably used at the receiving side in the de-interleaver, because such a sequence can be simply implemented. At the transmission side, for example an interleaver comprising a ROM is then used, the ROM containing the inverse permutation of what the de-interleaver contains at the receiving side. Given the permutation realised by the interleaver, this inverse permutation can be calculated, for example numerically. If a recurrent pattern of mutually different series of addresses is used in the de-interleaver, including a monotonously ascending series (1, 2, 3), this inverse permutation requires only a limited amount of space in the memory ROM.

When different address series are used, a synchronization signal is desirable between the receiving side and the transmission side, so that the de-interleaver can start the pattern of series of addresses in the correct phase (so as to serve as the inverse of the interleaver). For this purpose use is preferably made of a transmitted synchronization signal which also serves to mark header information for the further processing of the encoded symbol.

Fig. 4 shows an embodiment of an address generator 54 for use in an interleaver as shown in Fig. 2 or 3. The address generator 54 comprises a register 60, an output of which is coupled to the output of the address generator and to a first multiplicand multiplier 62. The output of the multiplier 62 is coupled to a first summand input of an adder 64. The output of the adder 64 is coupled to an input of the register 60. The address generator comprises a factor memory 63 and a summand memory 65 which are coupled, by way of an output, to a second multiplicand input of the multiplier 62 and to a second summand input of the adder 64, respectively.

During operation the register 60 contains the address $X_n$ for the memory. Using the multiplier 62 and the adder 64, the next address is calculated in conformity with the formula

$$X_{n+1} = (a\,X_n + c)\bmod M$$

where M is the length of the address series. The factor "a" and the summand "c" are derivec from the factor memory 63 and the summand memory 65, respectively. Between successive series the memories 63, 65 receive signals, whereby another factor and/or summand is applied to the multiplier and the adder, so that subsequently a different series is generated. In one of the series, for example a=1 and c=1, resulting in a monotonously ascending series. In the other series a is then unequal to 1 and is chosen, in a manner which is known per se, so as to generate a pseudo-random sequence (c relative prime with respect to M, a-1 is a multiple of p for all primes p sharing M (e.g. if M=45=3*3*5 then a-1 must be a multiple of both 3 and 5) and a-1 is a multiple of 4 if M is a multiple of 4).

By storing a number of different usable values of a and c, a corresponding number of different series of addresses can be generated.

Preferably, the "a" values are selected only such that (a-1) squared is divisible by "M", i.e. such that (a-1) contains each prime factor of m at least half as many times as "M" itself (for example when M=675=3*3*3*5*5, (a-1) could be 45=3*3*5, in general large M values with several prime factors are required: of the M values of 1 to 20 only M=8, 9, 12, 16, 18 qualify). It can be proven that, when only "a" values having the property that the square of (a-1) is divisble by M are used for generating the addresses, any pseudo random permutation of the bits described by the formula $X_{n+1} = (a\,X_n + c)\bmod M$ can be realized with an "a" value that also satisfies this condition. Also it has been found that both the addresses for interleaving and deinterleaving can then be realized with such pseudo random permutations in that case. Hence no address ROM is needed. It has been found that this is true only when the square of (a-1) is divisible by M. In this case the addresses need not be calculated by actually caluliating the formula $X_{n+1} = (a\,X_n + c)\bmod M$. In stead, one may use $X_{n+1} = X_n + v_n \bmod m$; $v_{n+1} = v_n + d \bmod m$, with d=c(a-1), and $v_0$ initialized to $(a-1)X_0 + c$. (For example, when M=100(=2*2*5*5), "a" may be chosen as 21 (a-1=4*5) and c=1).

When the modulus M with which the multiplier and adder operate is made adjustable, the interleaver/de-interleaver can be simply switched between different block lengths.

Evidently, the invention is not restricted to the embodiments given. For example, instead of operating with bits it is also possible to operate with larger symbols, for as long as the error correction code is capable of correcting random and isolated errors in these symbols better than random errors in the form of a burst.

Furthermore, the logic succession of bits produced by the encoder is not necessarily a temporal succession. Bits are "logically successive" if simultaneous errors in these bits can be corrected less readily than simultaneous errors in "non-logically successive bits.

The inner frequency interleaving is a pseudo-random bit interleaving. The interleaving is on a block basis, *i.e.*, the bits in each OFDM symbol are permuted in a fixed way such that bursts are randomized. However, bits of a given OFDM symbol are not mixed with bits originating from any other OFDM symbol.

In a practical example, an OFDM symbol consists of N useful subcarriers, where N equals 6361 or 5937, that each contain 2, 4 or 6 bits of information. The task of the interleaver is to decorrelate the bits at the input of a Viterbi detector.

The (de)interleaver consists of a memory (RAM) having the size of 8 times 8192 bit and an addressing unit. The addressing unit generates a 16 bit address that can be distinguished in 3 lsb bits and 13 msb bits. The 13 msb bits determine a particular subchannel, while the 3 lsb bits determine which bit from a given subchannel. Each time as the RAM is addressed, the contents are read and put forward to the downstreamdecoder and the next bit at the input is written in the current location. At each cycle, all relevant locations must be addressed. The three lsb bits periodically go through relevant states (dependent on the number of bits per symbol), while the 13 msb bits are generated by an algorithm producing all relevant addresses in a special sequence.

Since 6361 is prime and 5937 is divisible by three, the lsb addresses can be generated in pairs, an algorithm is defined that works for 2 bits of information per subcarrier and this algorithm is used 1, 2 or 3 times dependent on the number of bits per symbol, each time with a different fixed offset on the lsb. In this way it is assured that all bits will be addressed under all circumstances before the addressing unit will be in the same state.

One way of producing a periodic interleaver would be to generate the consecutive addresses $x_{t,n}$, $0 \leq n < N$ of the 13 msb bits in the OFDM symbol at time t according to:

$$x_{t,n+1} = x_{t,n} + c_t \bmod N \qquad\qquad (1)$$

with $x_{t,0} = 0$ V t and GCD($c_t$,N) = 1. The increment $c_t$ depends on the time t. For a periodic interleaver, we can choose $c_t = c_{t-1} * c_0 \bmod N$, where $c_0$ is a judiciously chosen initial increment that corresponds to the actually realized interleave depth.

In summary, the invention relates to a transmission system, which comprises an encoder, an interleaver, a modulator, a transmission channel, a demodulator a deinterleaver and a decoder. The encoder is used for encoding a data block in an error correction code containing a logic succession of data items. The decoder is used for correcting errors in the transmission between the encoder and the decoder. The error correction code is more robust to errors which occur simultaneously and in an isolated fashion in the logic succession than to errors which occur simultaneously and in the form of a burst therein. The modulator is used for generating a signal which comprises a number of frequency channels to be transmitted simultaneously, each of the frequency channels corresponding to a group which comprises at least one of the data items and is modulated in the respective channel. The transmission channel is located between the modulator and the demodulator. The demodulator reconstructs the groups and applies the groups to the decoder. The interleaver distributes the data items between the groups and introduces a pseudo-random relationship between the logic succession and the distribution between the successive frequency channels. The de-interleaver reconstructs the logic succession from the groups reconstructed by the demodulator, before presentation to the decoder.

This transmission system can be improved when the interleaver and/or the de-interleaver realise the distribution by way of a non-monotonous linear congruential sequence.

The transmission system can be further improved when the interleaver and/or the de-interleaver are provided with a memory for the data items and with write and read means, the write means writing each time a data item in a location of the memory which has just been read before the read means read a data item from a next location of the memory, and in which an order of locations in which the logic succession is written differs for successive logic successions.

A further improvement concerns a transmission system in which the orders are periodically recurrent with a period of at least two blocks in which one monotonously ascending or descending order occurs. Also the write and/or read means may comprise an address generator which is arranged to form a linear congruential sequence with a factor and a summand, and also arranged to replace the factor and/or the summand from one block to another.

Thus information can be transmitted by the following steps:

- encoding the data in an error correction code
- interleaving the data according to a pseudo-random sequence
- modulating the data in a series of frequency channels, data items which cannot be corrected together being arranged in separate frequency channels by interleaving,
- demodulating the data
- de-interleaving the data
- decoding the data.

Fig. 5 shows an embodiment of the transmitting section according to the invention. The transmitting section contains a data bus 70 and a address bus 71 connecting a memory 72, a processor 76 and a transmitter 78. An encoder 74 is coupled to the data bus 70. The encoder 74 is coupled to the address bus 71 via an address generation unit 75.

In operation, the encoder 74 receives the data block and encodes it as a succession of bits. Each successive bit is fed to the data bus 70, and the presence of the bit is signalled to the address generator 75. The address generator 75 generates a respective address for each successive bit according to the pseudo random sequence. The address indicates both a word location in the memory 72 and a bit location within the word location. The word location corresponds to the group to which the bit is assigned, and the bit location corresponds to the location of the bit within the group. The address generator 75 ensures that bits which are logically adjacent are substantially always stored in different word locations. The spacing of these word locations is preferably larger than zero, so that logically adjacent bits will enter non-adjacent word locations.

The address is applied to the data bus and the bit is stored in the memory 72 at a location that corresponds to the address generated for it by the address generator 75. When the entire data block has thus been encoded in the error protecting code, and stored in the memory 72, the processor 76 is started. The processor 76 computes the FFT of the words stored in memory 72. For this purpose, it reads the words each time as they are needed for the FFT algorithm. For this purpose a known FFT algorithm can be used, which addresses the word locations of the memory 72 in a normal way, i.e. without requiring knowledge of the interleaving process. Because the bits which are logically adjacent have substantially always stored in different word locations, these adjacent bits are modulated in different frequency channels in the result of the FFT. This result is subsequently read by the transmitter 78 and transmitted via the transmission channel (not shown).

A structure similar to that of Fig. 5 can be used for the receiving section, with a receiver replacing the transmitter 78 and a decoder replacing encoder 74. In this case the receiver writes words into memory 72 and the processor 76 performs an FFT on this words. Address generator 75 effects the pseudo random interleaving, issuing successive word/bit address pairs to read out the results of the FFT bit by bit for error correction by the decoder.

## Claims

1. A method of error protected transmission and reception of data, the method comprising:

    - a transmitting step comprising transmitting data-items that are encoded according to a convolution error correcting code and subsequently pseudo-random interleaved, the data-items being transmitted modulated in a number of simultaneously active frequency channels;
    - a receiving step comprising receiving, de-interleaving and decoding the transmitted data-items according to the convolution error correcting code,

    **characterized in that** the de-interleaving comprises writing the received data-items into locations in a memory in an order of writing, and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function, the data-items being interleaved so as to provide an inverse of the de-interleaving.

2. A method according to claim 1, wherein

    - the transmission step comprises:

        - encoding the data in each version of the basic cycle into a respective logic succession of data-items in the convolution error correction code which is more robust against errors that are separate from each other than against errors that occur in a burst in the respective logic succession;
        - generating a signal comprising the frequency channels, the data-items for a version of the basic cycle being modulated in respective ones of the frequency channels that are simultaneously active;
        - selecting for each particular data-item a particular frequency channel dependent on a particular position of the data-item in its logic succession;
        - modulating each frequency channel of the signal in dependence on at least a respective one of the data items, the particular data item being modulated at the particular frequency channel;
        - transmitting the signal;

- a receiving step comprising:

- receiving the signal;
- demodulating the data-items from frequency channels of the signal;
- inverse selecting the logic position of the particular data-item in its respective logic succession, dependent on the particular frequency channel from which the particular data-item was demodulated;
- decoding the data-items received from the reading means according to the convolution error correcting code applied to the logic sequence obtained by said inverse selecting;

**characterized in that** the inverse selecting comprises:

- upon reception from the demodulation, writing the data items from each particular version of the basic cycle into a memory in an order of writing addresses for the particular version;
- reading the data items for that particular version from the memory in an order of reading addresses for the particular version, permuted according to a pseudo random function with respect to the order of writing addresses for the particular version, the writing of the data-items of the particular version being performed at addresses as these addresses come available during reading of the data items of a directly preceding version of the basic cycle;
- generating the orders of writing and reading addresses, the order of reading addresses in the particular version of the basic cycle being permuted with respect to the order of reading addresses used in a directly preceding version of the basic cycle according to the pseudo random function, the pseudo random function being particular to the version of the basic cycle; the order of reading and writing addresses being repeated periodically, each order of reading addresses recurring each time after a period of exactly two versions of the basic cycle, the order of reading addresses being alternately a monotonously ascending or descending order of addresses and an order in which the addresses for reading are pennuted according to the pseudo random function;

wherein said selecting in the transmission step comprises selecting the particular frequency channel for positions in each respective logic succession so as to provide an inverse of the assignment of data-items from frequency channels to positions in the respective logic succession performed by the inverse selecting of the receiving step.

3. A method of transmission according to claim 2, in which the addresses of the memory locations are calculated according to a linear congruential sequence satisfying

$$Xn+1 = ( a\, Xn + c )\bmod M$$

n being the position of a particular data-item in the order of reading addresses, Xn being the address from which that particular data item is read, M being the number of selectable memory locations, a and c being a factor and a summand for a linear congruential sequence respectively, the combination of the factor and the summand being changed for each version of the basic cycle.

4. A receiving method for reception of error protected data with data items being transmitted modulated in a number of simultaneously active frequency channels, the receiving method comprising receiving, de-interleaving and decoding the transmitted data according to a convolution error correction code, **characterized in that** de-interleaving comprises writing the received data-items into locations in a memory in an order of writing and reading the data-items in a de-interleaved order of reading, de-interleaving being performed in successive versions of a basic cycle, the data-items for a version of the basic cycle being in the locations as they become available on reading for a directly preceding version of the basic cycle, the order of writing the data-items in successive cycles being alternately an order of locations with monotonously ascending or descending addresses and an order with addresses permuted according to a pseudo random function.

5. A transmitting method for error protected transmission of data, the transmitting method comprising transmitting data items that are encoded according to a convolution error correcting code and subsequently pseudo random interleaved, the data items being transmitted modulated in a number of simultaneously active frequency channels, **characterized in that** the data items are interleaved so as to provide an inverse of de-interleaving that is obtained by writing the received data-items into locations in a memory in an order of writing and reading the data-items in a de-interleaved order of reading, de-interleaving being performed in successive versions of a basic cycle, the data-items for a version of the basic cycle being in the locations as they become available on reading for a directly preceding version of the basic cycle, the order of writing the data-items in successive cycles being alternately an order of locations with monotonously ascending or descending addresses and an order with addresses permuted according to a pseudo random function.

6. A transmitting method according to claim 5, said transmitting method comprising:

- writing the data items from each logic succession into a further memory in a further order of writing addresses for the particular version of the basic cycle;
- reading the data items for that particular version from the further memory in a further order of reading addresses for the particular version, permuted according to an inverse of the pseudo random function with respect to the further order of writing addresses for the particular version, the writing of the data-items of the particular version being performed at addresses as these addresses come available during reading of the data items from the further memory during a directly preceding version of the basic cycle;
- generating the further orders of writing and reading addresses, the further order of reading addresses in the particular version of the basic cycle being permuted with respect to the further order of reading addresses used in a directly preceding version of the basic cycle according to the inverse of the pseudo random function, the inverse of the pseudo random function being particular to the version of the basic cycle,

wherein the further order of reading and writing addresses is repeated periodically, each further order of reading addresses recurring each time after a period of exactly two versions of the basic cycle, the further order of reading addresses being alternately a monotonously ascending or descending order of addresses and a further order in which the addresses for reading are permuted according to the inverse of the pseudo random function.

7. A system for error protected transmission and reception of data, the system comprising:

- a transmitting section for encoding data items according to a convolution error correcting code and subsequently pseudo-random interleaving the data items, the data-items being transmitted modulated in a number of simultaneously active frequency channels and transmitted via a transmission channel;
- a receiving section for receiving, de-interleaving and decoding the transmitted data-items according to the convolution error correction code,

**characterized in that** the receiving section comprises a memory, de-interleaving in the receiving section comprising writing the received data-items into locations in the memory in an order of writing and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function, the transmitting section being arranged to interleave the data-items so as to provide an inverse of the de-interleaving.

8. A system according to claim 7, the system comprising:

- the transmitter section comprising:

- an encoder (10) for encoding the data in each version of the basic cycle into a respective logic succession of data-items in a convolution error correction code which is more robust against errors that are separate from each other than against errors that occur in burst in the respective logic succession;
- a signal generator (14) for generating a signal comprising a number of frequency channels the data-items for a version of the basic cycle being modulated in respective ones of the frequency channels that are simultaneously active;
- selecting means (12) for selecting for each particular data-item a particular frequency channel dependent on a particular position of the data-item in its logic succession;
- a modulator (14) for modulating each frequency channel of the signal in dependence on at least a respective one of the data items, the particular data item being modulated at the particular frequency channel;
- a transmitter for transmitting the signal via the transmission channel;

- a receiving section comprising:

- a reception input for receiving the signal from the transmission channel;
- a demodulator (16) for demodulating the data-items from frequency channels of the signal;
- inverse selecting means (18, 52, 54, 56) for selecting the logic position of the particular data-item in its respective logic succession, dependent on the particular frequency channel from which the particular data-item was demodulated;
- a decoder for decoding the data-items received according to the convolution error correcting code applied to the logic sequence as obtained by the inverse selecting means (18, 52, 54, 56);

**characterized in that** the inverse selecting means (18, 52, 54, 56) comprise:

- a memory;
- writing means for, upon reception from the demodulator (16), writing the data items from each particular version of the basic cycle into the memory in an order of writing addresses for the particular version;
- reading means for reading the data items for that particular version from the memory in an order of reading addresses for the particular version, permuted according to a pseudo random function with respect to the order of writing addresses for the particular version, the writing means writing the data-items of the particular version at addresses as these addresses come available during reading of the data items of a directly preceding version of the basic cycle;
- address generating means (52, 54) for generating the orders of writing and reading addresses, the order of reading addresses in the particular version of the basic cycle being permuted with respect to the order of reading addresses used in a directly preceding version of the basic cycle according to the pseudo random function, the pseudo random function being particular to the version of the basic cycle; the address generating means generating the order of reading and writing addresses periodically, each order of reading addresses recurring each time after a period of exactly two versions of the basic cycle, the order of reading addresses being alternately a monotonously ascending or descending order of addresses and an order in which the addresses for reading are permuted according to the pseudo random function;

the selecting means (12) of the transmitting section selecting the particular frequency channel for positions in each respective logic succession so as to provide an inverse of the assignment of data-items from frequency channels to positions in the respective logic succession performed by the inverse selecting means (18, 52, 54, 56) of the receiving section.

9. Transmission system according to claim 8, in which the addresses of the memory locations are calculated according to a linear congruential sequence satisfying

$$Xn+1 = ( a\, Xn + c )\bmod M$$

n being the position of a particular data-item in the order of reading addresses, Xn being the address from which that particular data item is read, M being the number of selectable memory locations, a and c being a factor and a summand for a linear congruential sequence respectively, the combination of the factor and the summand being changed for each version of the basic cycle.

10. A receiving device for a system for error protected transmission and reception of data, the receiving device being arranged to receive, de-interleave and decode the transmitted data-items according to a convolution error correcting code,
**characterized in that** the receiving device comprises a memory, de-interleaving in the receiving section comprising writing the received data-items into locations in the memory in an order of writing and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function.

11. A transmitting device for a system for error protected transmission and reception of data, the transmitting device being arranged to encode data items according to a convolution error correcting code and subsequently pseudo-random interleave the data items, the data-items being transmitted modulated in a number of simultaneously active frequency channels and transmitted via a transmission channel, **characterized in that** the transmitting device is arranged to interleave the data-items so as to provide an inverse of a de-interleaving that comprises writing the received data-items into locations in a memory in an order of writing and reading the data-items in a de-interleaved order of reading, de-interleaving being performed in successive versions of a basic cycle, the data-items for a version of the basic cycle being written in the locations as the locations become available on reading for a directly preceding version of the basic cycle, the order of writing the data-items in successive cycles being alternately an order of locations with monotonously ascending or descending addresses and an order with addresses permuted according to a pseudo random function

12. A transmitting device according to claim 11, the selecting means (12) in the transmitting device comprising:

- writing means for writing the data items from each logic succession into a further memory in a further order of writing addresses for the particular version of the basic cycle;
- reading means for reading the data items for that particular version from the further memory in a further order of reading addresses for the particular version, permuted according to an inverse of the pseudo random function with respect to the further order of writing addresses for the particular version, the writing of the data-items of the particular version being performed at addresses as these addresses come available during reading of the data items from the further memory during a directly preceding version of the basic cycle;
- generating means (52, 54) for generating the further orders of writing and reading addresses, the further order of reading addresses in the particular version of the basic cycle being permuted with respect to the further order of reading addresses used in a directly preceding version of the basic cycle according to the inverse of the pseudo random function, the inverse of the pseudo random function being particular to the version of the basic cycle, wherein the further order of reading and writing addresses is repeated periodically, each further order of reading addresses recurring each time after a period of exactly two versions of the basic cycle, the further order of reading addresses being alternately a monotonously ascending or descending order of addresses and a further order in which the addresses for reading are permuted according to the inverse of the pseudo random function.

**Patentansprüche**

1. Verfahren zur fehler-geschützten Übertragung und zum Empfang von Daten, wobei das Verfahren umfasst:

einen Übertragungsschritt, der das Übertragen von Daten-Posten umfasst, welche gemäß einem Faltungsfehler-Korrekturcode codiert werden und im wesentlichen pseudo-zufallsverschachtelt sind, wobei die Daten-Posten übertragen werden, die in einer Anzahl von simultan aktiven Frequenzkanälen moduliert sind;
einen Empfangsschritt, der das Empfangen, Entschachteln und Decodieren der übertragenen Daten-Posten umfasst, gemäß dem Faltungsfehler-Korrekturcode, **dadurch gekennzeichnet, dass** das Entschachteln das Schreiben der empfangenen Daten-Posten in Stellen in einem Speicher in einer Entschachtelungs-Lesereihenfolge und das Lesen der Daten-Posten in einer Entschachtelungs-Lesereihenfolge umfasst, wobei das Entschachteln in aufeinanderfolgenden Versionen eines Basiszyklus durchgeführt wird, wobei die Daten-Posten für eine Version des Basiszyklus in die Stellen als die Stellen geschrieben werden, welche beim Lesen für eine unmittelbar vorhergehende Version des Basiszyklus verfügbar sind, wobei die Reihenfolge zum Schreiben der Daten-Posten in aufeinanderfolgenden Zyklen abwechselnd eine Reihenfolge von Stellen ist mit monoton ansteigenden oder abnehmenden Adressen, und eine Reihenfolge mit Adressen, welche gemäß einer Pseudozufallsfunktion vertauscht sind, wobei die Daten-Posten so verschachtelt werden, um eine Umkehrung der Entschachtelung zu sein.

2. Verfahren nach Anspruch 1, wobei der Übertragungsschritt umfasst:

- Codieren der Daten in jeder Version des Basiszyklus in eine entsprechende logische Aufeinanderfolge von Daten-Posten im Faltungsfehler-Korrekturcode, der robuster gegenüber Fehlern ist, welche separat voneinander sind, als gegenüber Fehlern, welche in einem Burst in der entsprechenden logischen Aufeinanderfolge auftreten;
- Erzeugen eines Signals, welches die Frequenzkanäle umfasst, wobei die Daten-Posten für eine Version des Basiszyklus in entsprechenden der Frequenzkanäle moduliert werden, welche simultan aktiv sind;

- Auswählen, für jeden besonderen Daten-Posten, eines bestimmten Frequenzkanals abhängig von einer bestimmten Position des Daten-Postens in seiner logischen Aufeinanderfolge;
- Modulieren eines jeden Frequenzkanals des Signals in Abhängigkeit von zumindest einem der Daten-Posten, wobei der bestimmte Daten-Posten bei dem bestimmten Frequenzkanal moduliert wird;
- Übertragen des Signals;

ein Empfangsschritt umfasst:

- Empfangen eines Signals;
- Demodulieren der Daten-Posten von Frequenzkanälen des Signals;
- inverses Auswählen der logischen Position des bestimmten Daten-Postens in seiner entsprechenden logischen Aufeinanderfolge, abhängig von dem bestimmten Frequenzkanal, von dem der bestimmte Daten-Posten demoduliert wurde;
- Decodieren der Daten-Posten, welche von der Leseeinrichtung empfangen wurden, gemäß dem Faltungsfehler-Korrekturcode, der bei der logischen Sequenz angewandt wurde, welche durch das inverse Auswählen erlangt wurde; **dadurch gekennzeichnet, dass** das inverse Auswählen umfasst:
- beim Empfang von der Demodulation, Schreiben der Daten-Posten von jeder bestimmten Version des Basiszyklus in einen Speicher in einer Reihenfolge von Schreibadressen für die bestimmte Version;
- Lesen der Daten-Posten für diese bestimmte Version vom Speicher in einer Leseadress- Reihenfolge für die bestimmte Version, vertauscht gemäß einer Pseudofunktion in Bezug auf die Reihenfolge zum Schreiben der Adressen für die bestimmte Version, wobei das Schreiben der Daten-Posten der bestimmten Version bei Adressen durchgeführt wird, wenn diese Adressen während des Lesens der Daten-Posten einer unmittelbar vorhergehenden Version des Basiszyklus verfügbar sind;
- Erzeugen der Reihenfolgen zum Schreiben und Lesen der Adressen, wobei die Reihenfolge zum Lesen der Adressen in der bestimmten Version des Basiszyklus in Bezug auf die Reihenfolge von Leseadressen vertauscht wird, indem eine unmittelbar vorhergehende Version des Basiszyklus gemäß einer Pseudozufallsfunktion verwendet wird, wobei die Pseudozufallsfunktion speziell für die Version des Basiszyklus ist; wobei die Reihenfolge zum Lesen und Schreiben der Adressen periodisch wiederholt wird, wobei jede Reihenfolge zum Lesen der Adressen jedes Mal nach einer Periode von exakt zwei Versionen des Basiszyklus wiederkehrt, wobei die Reihenfolge zum Lesen der Adressen abwechselnd eine monoton ansteigende oder abfallende Reihenfolge von Adressen ist und eine Reihenfolge ist, bei der die Adressen zum Lesen gemäß der Pseudozufallsfunktion vertauscht sind;
- wobei das Auswählen im Übertragungsschritt das Auswählen des bestimmten Frequenzkanals für Positionen in jeder entsprechenden logischen Auseinanderfolge umfasst, um eine Umkehrung der Zuordnung von Daten-Posten von Frequenzkanälen auf Positionen in der entsprechenden logischen Aufeinanderfolge bereitzustellen, welche durch inverses Auswählen des Empfangsschritts durchgeführt wird.

3. Übertragungsverfahren nach Anspruch 2, bei dem die Adressen der Speicherstellen gemäß einer linearen übereinstimmenden Sequenz berechnet werden, welche erfüllt:

$$Xn+1 = (aXn + c) \bmod M$$

wobei n die Position eines bestimmten Daten-Postens in der Reihenfolge von Leseadressen ist, Xn die Adresse ist, von welcher der bestimmte Daten-Posten gelesen wird, M die Anzahl auswählbarer Speicherstellen ist, a und c ein Faktor ist bzw. ein Summand für eine lineare übereinstimmende Sequenz ist, wobei die Kombination von Faktor und Summand für jede Version des Basiszyklus geändert werden.

4. Empfangsverfahren zum Empfang von fehler-geschützten Daten, wobei Daten-Posten übertragen werden, die in einer Anzahl von simultan aktiven Frequenzkanälen moduliert wurden, wobei das Empfangsverfahren das Empfangen, Entschachteln und Decodieren der übertragenen Daten gemäß einem Faltungsfehler-Korrekturcode umfasst, **dadurch gekennzeichnet, dass** das Entschachteln das Schreiben der empfangenen Daten-Posten in Stellen in einem Speicher in einer Reihenfolge zum Schreiben und Lesen der Daten-Posten in einer entschachtelten Reihenfolge umfasst, wobei das Entschachteln in aufeinanderfolgenden Versionen eines Basiszyklus durchgeführt wird, wobei die Daten-Posten für eine Version des Basiszyklus in den Stellen sind, wenn sie beim Lesen verfügbar werden, für eine unmittelbar vorhergehende Version des Basiszyklus, wobei die Reihenfolge zum Schreiben der Daten-Posten in aufeinanderfolgenden Zyklen abwechselnd eine Reihenfolge von Stellen mit monoton ansteigenden oder abfallenden Adressen und eine Reihenfolge mit Adressen sind, welche gemäß einer Pseudozufallsfunktion vertauscht sind.

5. Übertragungsverfahren für fehlergeschützte Übertragung von Daten, wobei das Übertragungsverfahren das Übertragen von Daten-Posten umfasst, welche gemäß einem Faltungsfehler-Korrekturcode codiert und nachfolgend pseudozufallsverschachtelt sind, wobei die Daten-Posten übertragen werden, welche in einer Anzahl von simultan aktiven Frequenzkanälen moduliert sind, **dadurch gekennzeichnet, dass** die Daten-Posten verschachtelt werden, um eine Umkehrung der Entschachtelung bereitzustellen, welche erlangt wird, indem die empfangenen Daten-Posten in Stellen in einem Speicher in einer Schreibreihenfolge und Lesereihenfolge in einer entschachtelten Lesereihenfolge geschrieben werden, wobei das Verschachteln in aufeinanderfolgenden Versionen eines Basiszyklus durchgeführt wird, wobei die Daten-Posten für eine Version des Basiszyklus, in den Stellen sind, wenn sie beim Lesen verfügbar sind, für eine unmittelbar vorhergehende Version des Basiszyklus, wobei die Reihenfolge zum Schreiben der Daten-Posten in aufeinanderfolgenden Zyklen abwechselnd eine Reihenfolge von Stellen mit monoton ansteigenden oder abfallenden Adressen ist, und eine Reihenfolge mit Adressen ist, welche gemäß einer Pseudozufallsfunktion vertauscht sind.

6. Übertragungsverfahren nach Anspruch 5, wobei das Übertragungsverfahren umfasst:

- Schreiben der Daten-Posten von jeder logischen Aufeinanderfolge in einen weiteren Speicher in einer weiteren Reihenfolge von Schreibadressen für eine bestimmte Version des Basiszyklus;
- Lesen der Daten-Posten für diese bestimmte Version von dem weiteren Speicher in einer weiteren Reihenfolge von Leseadressen für die bestimmte Version, vertauscht gemäß einer Umkehrung der Pseudozufallsfunktion mit Bezug auf die weitere Reihenfolge von Schreibadressen für die bestimmte Version, wobei das Schreiben der Daten-Posten der bestimmten Version bei Adressen durchgeführt wird, wenn diese Adressen während des Lesens der Daten-Posten von dem weiteren Speicher verfügbar werden, während einer unmittelbar vorhergehenden Version des Basiszyklus,;
- Erzeugen der weiteren Reihenfolgen zum Schreiben und Lesen der Adressen, wobei die weitere Reihenfolge zum Lesen der Adressen in der bestimmten Version des Basiszyklus in Bezug auf die weitere Reihenfolge von Leseadressen vertauscht wird, welche in einer unmittelbar vorhergehenden Version des Basiszyklus verwendet werden, gemäß der Umkehrung der Pseudozufallsfunktion, wobei die Umkehrung der Pseudozufallsfunktion speziell für die Version des Basiszyklus ist, wobei die weitere Reihenfolge zum Lesen und Schreiben der Adressen periodisch wiederholt wird, wobei jede weitere Reihenfolge zum Lesen der Adressen jedes Mal nach einer Periode von exakt zwei Versionen des Basiszyklus wiederkehrt, wobei die weitere Reihenfolge zum Lesen der Adressen abwechselnd eine monoton ansteigende oder abfallende Reihenfolge von Adressen und eine weitere Reihenfolge ist, in welcher die Adressen zum Lesen gemäß der Umkehrung der Pseudozufallsfunktion vertauscht werden.

7. System zur fehler-geschützten Übertragung und zum Empfang von Daten, wobei das System umfasst:

einen Übertragungsabschnitt zum Codieren von Daten-Posten gemäß einem Faltungsfehler-Korrekturcode und nachfolgendem Pseudozufalls-Verschachteln der Daten-Posten, wobei die Daten-Posten übertragen werden, die in einer Anzahl von simultan aktiven Frequenzkanälen moduliert übertragen sind und über einen Übertragungskanal übertragen werden;
einen Empfangsabschnitt zum Empfangen zum Empfangen, Entschachteln und Decodieren der übertragnen Daten-Posten gemäß dem Faltungsfehler-Korrekturcode,

**dadurch gekennzeichnet, dass** der Empfangsabschnitt einen Speicher umfasst, wobei das Entschachteln im Empfangsabschnitt das Schreiben der empfangenen Daten-Posten in Stellen im Speicher umfasst, in einer Reihenfolge zum Schreiben und Lesen der Daten-Posten in einer entschachtelten Lesereihenfolge, wobei das Entschachteln in aufeinanderfolgenden Versionen eines Basiszyklus durchgeführt wird, wobei die Daten-Posten für eine Version des Basiszyklus in die Stellen geschrieben werden, wenn die Stellen verfügbar werden, beim Lesen für eine unmittelbar vorhergehende Version des Basiszyklus, wobei die Reihenfolge zum Schreiben der Daten-Posten in aufeinanderfolgenden Zyklen abwechselnd eine Reihenfolge von Stellen mit ansteigenden oder abfallenden Adressen und eine Reihenfolge mit Adressen ist, welche gemäß einer Pseudozufallsfunktion vertauscht wurden, wobei der Übertragungsabschnitt eingerichtet ist, die Daten-Posten so zu verschachteln, um eine Umkehrung des Entschachteln bereitzustellen.

8. System nach Anspruch 7, wobei das System umfasst:

- den Übertragungsabschnitt, der umfasst:

- einen Codierer (10) zum Codieren der Daten in jeder Version des Basiszyklus in eine entsprechende logische Aufeinanderfolge von Daten-Posten in einen Faltungsfehler-Korrekturcode, der gegenüber Fehlern, welche separat voneinander sind, robuster ist als gegenüber Fehlern, welche in einem Burst in der entsprechenden logischen Aufeinanderfolge auftreten;
- einen Signalgenerator (14) zum Erzeugen eines Signals, welches eine Anzahl von Frequenzkanälen umfasst, wobei die Daten-Posten für eine Version des Basiszyklus in entsprechenden der Frequenzkanäle, die simultan aktiv sind, moduliert sind
- eine Auswahleinrichtung (12) zum Auswählen - für jeden bestimmten Daten-Posten - eines Frequenzkanals in Abhängigkeit von einer bestimmten Position in dessen logischer Aufeinanderfolge;
- einen Modulator (14) zum Modulieren jedes Frequenzkanals des Signals in Abhängigkeit von zumindest einem der Daten-Posten, wobei der bestimmte Daten-Posten bei dem bestimmten Frequenzkanal moduliert ist;
- einen Übertrager zum Übertragen des Signals über den Übertragungskanal;

einen Empfangsabschnitt, der umfasst:

- einen Empfangseingang zum Empfangen des Signals vom Übertragungskanal;
- einen Demodulator (16) zum Demodulieren der Daten-Posten von Frequenzkanälen des Signals;
- ein Invers-Auswahleinrichtung (18, 52, 54, 56) zum Auswählen der logischen Position des bestimmten Daten-Postens in seiner logischen Aufeinanderfolge, abhängig von dem bestimmten Frequenzkanal, von dem der bestimmte Daten-Posten demoduliert wurde;
- eine Decoder zum Decodieren der Daten-Posten, welche gemäß dem Faltungsfehler-Korrekturcode empfangen werden, der bei der logischen Sequenz angewandt wurde, wie durch die Invers-Auswahleinrichtung erlangt,

**dadurch gekennzeichnet, dass** die Invers-Auswahleinrichtung (18, 52, 54, 56) umfasst:

- einen Speicher;
- eine Schreibeinrichtung zum Schreiben - bei Empfang vom Demodulator (16) -der Daten-Posten von jeder bestimmten Version des Basiszyklus in den Speicher in einer Reihenfolge von Schreibadressen für die bestimmte Version;
- eine Leseeinrichtung zum Lesen der Daten-Posten für diese bestimmte Version vom Speicher in einer Leseadress-Reihenfolge für die bestimmte Version, welche gemäß einer Pseudozufallsfunktion vertauscht wurde, in Bezug auf die Reihenfolge von Schreibadressen für die bestimmte Version, wobei die Schreibeinrichtung die Daten-Posten der bestimmten Version bei Adressen schreibt, wenn diese Adressen verfügbar werden, während des Lesens der Daten-Posten einer unmittelbar vorhergehenden Version des Basiszyklus;
- eine Adresserzeugungseinrichtung (52, 54) zum Erzeugen der Reihenfolgen zum Schreiben und Lesen der Adressen, wobei die Reihenfolge der Leseadressen in der bestimmten des Basiszyklus in Bezug auf die Reihenfolge der Leseadressen vertauscht ist, welche in einer unmittelbar vorhergehenden Version des Basiszyklus, verwendet werden, gemäß der Pseudozufallsfunktion, wobei die Pseudozufallsfunktion speziell für die Version des Basiszyklus, ist; wobei die Adresserzeugungseinrichtung die Reihenfolge zum periodischen Lesen und Schreiben der Adressen erzeugt, wobei jede Reihenfolge der Leseadressen jedes Mal nach einer Periode von exakt zwei Versionen des Basiszyklus wiederkehrt, wobei die Reihenfolge der Leseadressen abwechselnd eine ansteigende oder abfallende Reihenfolge von Adressen und eine Reihenfolge ist, in der die Adressen zum Lesen gemäß der Pseudozufallsfunktion vertauscht sind;

wobei die Auswahleinrichtung (12) des Übertragungsabschnitts den bestimmten Frequenzkanal für Positionen in jeder entsprechenden logischen Aufeinanderfolge auswählt, um eine Umkehrung der Zuordnung von Daten-Posten bereitzustellen, von Frequenzkanälen auf Positionen in der entsprechenden logischen Aufeinanderfolge, welche durch die Invers-Auswahleinrichtung (18, 52, 54, 56) durchgeführt wurde.

9. Übertragungssystem nach Anspruch 8, bei dem die Adressen der Speicherstellen gemäß einer linearen übereinstimmenden Sequenz berechnet werden, welches erfüllt:

$$Xa + 1 = (aXn + c) \bmod M$$

wobei n die Position eines bestimmten Daten-Postens in der Reihenfolge von Leseadressen ist, Xn die Adresse ist, von welcher der bestimmte Daten-Posten gelesen wird, M die Anzahl auswählbarer Speicherstellen ist, und a und c ein Faktor bzw. ein Summand für eine lineare übereinstimmende Sequenz ist, wobei die Kombination von Faktor und Summand für jede Version des Basiszyklus geändert werden.

10. Empfangseinrichtung für ein System zur fehler-geschützten Übertragung und zum Empfang von Daten, wobei die Empfangseinrichtung eingerichtet ist, die übertragenen Daten-Posten gemäß einem Faltungsfehler-Korrekturcode zu empfangen, zu entschachteln und zu decodieren, **dadurch gekennzeichnet, dass** die Empfangseinrichtung einen Speicher umfasst, wobei das Entschachteln im Empfangsabschnitt das Schreiben der empfangenen Daten-Posten in Stellen im Speicher umfasst, in einer Reihenfolge zum Schreiben und Lesen der Daten-Posten in einer entschachtelten Reihenfolge zum Lesen, wobei das Entschachteln in aufeinanderfolgenden Versionen eines Basiszyklus durchgeführt wird, wobei die Daten-Posten für eine Version des Basiszyklus in die Stellen geschrieben werden, wenn die Stellen verfügbar werden, beim Lesen für eine unmittelbar vorhergehende Version des Basiszyklus, wobei die Reihenfolge zum Schreiben der Daten-Posten in aufeinanderfolgenden Zyklen abwechselnd eine Reihenfolge von Stellen mit ansteigenden oder abfallenden Adressen und eine Reihenfolge mit Adressen ist, welche gemäß einer Pseudozufallsfunktion vertauscht wurden.

11. Übertragungseinrichtung für ein System zur fehler-geschützten Übertragung und zum Empfang von Daten, wobei die Übertragungseinrichtung eingerichtet ist, Daten-Posten gemäß einem Faltungsfehler-Korrekturcode zu codieren und um nachfolgend die Daten-Posten pseudo-zufallsmäßig zu verschachteln, wobei die Daten-Posten übertragen werden, welche in einer Anzahl von simultan aktiven Frequenzkanälen moduliert wurden und über einen Übertragungskanal übertragen werden, **dadurch gekennzeichnet, dass** die Übertragungseinrichtung eingerichtet ist, die Daten-Posten so zu verschachteln, um eine Umkehrung einer Entschachtelung bereitzustellen, welche das Schreiben der empfangenen Daten-Posten in Stellen eines Speichers umfasst, in einer Schreibreihenfolge und einer Lesereihenfolge der Daten-Posten in einer entschachtelten Reihenfolge zum Lesen, wobei das Entschachteln in aufeinanderfolgenden Versionen eines Basiszyklus durchgeführt wird, wobei die Daten-Posten für eine Version des Basiszyklus in die Stellen geschrieben werden, wenn die Stellen beim Lesen verfügbar werden, für eine unmittelbar vorhergehende Version des Basiszyklus, wobei die Reihenfolge zum Schreiben der Daten-Posten in aufeinanderfolgenden Zyklen abwechselnd eine Reihenfolge von Stellen mit monoton ansteigenden oder abfallenden Adressen und eine Reihenfolge ist, welche gemäß einer Pseudozufallsfunktion vertauscht wurden.

12. Übertragungseinrichtung nach Anspruch 11, wobei die Auswahleinrichtung (12) in der Übertragungseinrichtung umfasst:

    - eine Schreibeinrichtung zum Schreiben der Daten-Posten von jeder logischen Aufeinanderfolge in einen weiteren Speicher in einer weiteren Reihenfolge der Schreibadressen für eine bestimmte Version des Basiszyklus;
    - eine Leseeinrichtung zum Lesen der Daten-Posten für diese bestimmte Version vom weiteren Speicher in einer weiteren Reihenfolge von Leseadressen für die bestimmte Version, vertauscht gemäß einer Umkehrung der Pseudozufallsfunktion in Bezug auf die weitere Reihenfolge von Schreibadressen für die bestimmte Version, wobei das Schreiben der Daten-Posten der bestimmten Version bei Adressen durchgeführt wird, wenn diese Adressen verfügbar werden, während des Lesens der Daten-Posten vom weiteren Speicher während einer unmittelbar vorhergehenden Version des Basiszyklus;
    - eine Erzeugungseinrichtung (52, 54) zum Erzeugen der weiteren Reihenfolgen von Schreib- und Leseadressen, wobei die weitere Reihenfolge von Leseadressen in der bestimmten Version des Basiszyklus in Bezug auf die weitere Reihenfolge von Leseadressen vertauscht wird, welche in einer unmittelbar vorhergehenden Version des Basiszyklus verwendet werden, gemäß einer Umkehrung der Pseudozufallsfunktion, wobei die Umkehrung der Pseudozufallsfunktion speziell für die Version des Basiszyklus ist, wobei die weitere Reihenfolge von Lese- und Schreibadressen periodisch wiederholt wird, wobei jede weitere Reihenfolge von Leseadressen jedes Mal nach einer Periode von exakt zwei Versionen des Basiszyklus wiederkehrt, wobei die weitere Reihenfolge von Leseadressen abwechselnd eine monoton ansteigende oder abfallende Reihenfolge von Adressen und eine weitere Reihenfolge ist, bei der die Adressen zum Lesen gemäß der Umkehrung der Pseudozufallsfunktion vertauscht werden.

**Revendications**

1. Procédé de transmission et de réception de données protégées contre les erreurs, le procédé comportant:

   - une étape de transmission comportant la transmission d'articles de données qui sont codés selon un code de correction d'erreurs de convolution et par conséquent entrelacés de façon pseudo aléatoire, les articles de données étant transmis modulés dans un nombre de canaux de fréquence simultanément actifs ;
   - une étape de réception comportant la réception, le désentrelacement et le décodage des articles de données transmis selon le code de correction d'erreurs de convolution,

   **caractérisé en ce que** le désentrelacement comporte l'écriture des articles de données reçus en des emplacements dans la mémoire dans l'ordre d'écriture, et la lecture des articles de données dans un ordre désentrelacé de lecture, le désentrelacement étant effectué dans des versions successives d'un cycle de base, les articles de données pour une version du cycle de base étant écrits dans des emplacements lorsque les emplacements deviennent disponibles lors de la lecture pour une version immédiatement précédente du cycle de base, l'ordre d'écriture des articles de données dans des cycles successifs étant alternativement un ordre d'emplacements avec des adresses croissant ou décroissant de façon monotone et un ordre avec des adresses permuté selon une fonction pseudo aléatoire, les articles de données étant entrelacés de manière à délivrer l'inverse du désentrelacement.

2. Procédé selon la revendication 1, dans lequel l'étape de transmission comporte :

   - le codage des données dans chaque version du cycle de base dans une succession logique respective d'articles de données dans le code de correction d'erreurs de convolution qui est plus robuste contre les erreurs qui sont distinctes les unes des autres que contre les erreurs qui se produisent en rafale dans la succession logique respective ;
   - la génération d'un signal comportant les canaux de fréquence, les articles de données pour une version du cycle de base étant modulés dans certains canaux respectifs des canaux de fréquence qui sont simultanément actifs ;
   - la sélection pour chaque article de données particulier d'un canal de fréquence particulier selon une position particulière de l'article de données dans sa succession logique ;
   - la modulation de chaque canal de fréquence du signal selon au moins un article de données respectif parmi les articles de données, l'article de données particulier étant modulé dans le canal de fréquence particulier ;
   - la transmission du signal ;

   une étape de réception comportant :

   - la réception du signal ;
   - la démodulation des articles de données à partir des canaux de fréquence du signal ;
   - la sélection inverse de la position logique de l'article de données particulier dans sa succession logique respective, selon le canal de fréquence particulier à partir duquel l'article de données particulier a été démodulé ;
   - le décodage des articles de données reçus depuis le moyen de lecture selon le code de correction d'erreurs de convolution appliqué à la séquence logique obtenue par ladite sélection inverse ;

   **caractérisé en ce que** la sélection inverse comporte :

   - lors de la réception à partir de la démodulation, l'écriture des articles de données à partir de chaque version particulière du cycle de base dans une mémoire dans l'ordre d'écriture des adresses pour la version particulière ;
   - la lecture des articles de données pour cette version particulière à partir de la mémoire dans un ordre de lecture d'adresses pour la version particulière, permuté selon une fonction pseudo aléatoire par rapport à l'ordre d'écriture des adresses pour la version particulière, l'écriture des articles de données de la version particulière étant effectuée à des adresses lorsque ces adresses sont disponibles pendant la lecture des articles de données d'une version immédiatement précédente du cycle de base ;
   - la génération des ordres d'écriture et de lecture des adresses, l'ordre de lecture des adresses dans la version particulière du cycle de base étant permuté par rapport à l'ordre de lecture des adresses utilisé dans une version immédiatement précédente du cycle de base selon la fonction pseudo aléatoire, la fonction pseudo aléatoire étant particulière à la version du cycle de base ; l'ordre de lecture et d'écriture des adresses étant répété périodiquement, chaque ordre de lecture d'adresses se répétant chaque fois après une période d'exactement deux versions du cycle de base, l'ordre de lecture des adresses étant alternativement un ordre croissant ou décroissant de façon monotone des adresses et un ordre dans lequel les adresses de lecture sont permutées selon la fonction pseudo aléatoire;

dans lequel ladite sélection au cours de l'étape de transmission comporte la sélection du canal de fréquence particulier pour des positions dans chaque succession logique respective de manière à délivrer un inverse de l'affectation des articles de données à partir des canaux de fréquence en des positions dans la succession logique respective effectuée par la sélection inverse de l'étape de réception.

3. Procédé de transmission selon la revendication 2, dans lequel les adresses des emplacements de mémoire sont calculées selon une séquence congruente linéaire satisfaisant

$$Xn+1 = (aXn+c) modM$$

n étant la position d'un article de données particulier dans l'ordre de lecture d'adresses, Xn étant l'adresse à partir de laquelle cet article de données particulier est lu, M étant le nombre d'emplacements de mémoire pouvant être sélectionné, a et c étant un facteur et un opérande de somme pour une séquence congruente linéaire respectivement, la combinaison du facteur et de l'opérande de somme étant changée pour chaque version du cycle de base.

4. Procédé de réception pour la réception de données protégées contre les erreurs comportant des articles de données transmis modulés dans un nombre de canaux de fréquence simultanément actifs, le procédé de réception comportant la réception, le désentrelacement et le décodage des données transmises selon un code de correction d'erreurs de convolution, **caractérisé en ce que** le désentrelacement comporte l'écriture des articles de données reçus dans des emplacements dans une mémoire dans un ordre d'écriture et de lecture des articles de données dans un ordre de désentrelacement de lecture, le désentrelacement étant effectué dans des versions successives d'un cycle de base, les articles de données pour une version du cycle de base se trouvant dans les emplacements lorsqu'ils deviennent disponibles lors de la lecture pour une version immédiatement précédente du cycle de base, l'ordre d'écriture des articles de données dans les cycles successifs étant alternativement un ordre d'emplacements avec des adresses croissant ou décroissantes de façon monotone et un ordre avec des adresses permutées selon une fonction pseudo aléatoire.

5. Procédé de transmission pour une transmission de données protégée contre les erreurs, le procédé de transmission comportant la transmission d'articles de données qui sont codés selon un code de correction d'erreurs de convolution et par conséquent entrelacés de façon pseudo aléatoire, les articles de données étant transmis modulés dans un nombre de canaux de fréquence simultanément actifs, **caractérisé en ce que** les articles de données sont entrelacés de manière à délivrer l'inverse du désentrelacement qui est obtenu en écrivant les articles de données reçus dans des emplacements dans une mémoire dans l'ordre d'écriture et de lecture des articles de données selon un ordre désentrelacé de lecture, le désentrelacement étant effectué dans des versions successives d'un cycle de base, les articles de données pour une version du cycle de base se trouvant dans des emplacements lorsqu'ils deviennent disponibles lors de la lecture pour une version immédiatement précédente du cycle de base, l'ordre d'écriture des articles de données dans des cycles successifs étant alternativement un ordre d'emplacements avec des adresses croissant et décroissantes de façon monotone et un ordre avec des adresses permutées selon une fonction pseudo aléatoire.

6. Procédé de transmission selon la revendication 5, ledit procédé de transmission comportant :

- l'écriture des articles de données à partir de chaque succession logique dans une autre mémoire dans un autre ordre d'écriture d'adresses pour la version particulière du cycle de base ;
- la lecture des articles de données pour cette version particulière à partir de l'autre mémoire dans un autre ordre de lecture d'adresses pour la version particulière, permutée selon l'inverse de la fonction pseudo aléatoire par rapport à l'autre ordre d'écriture d'adresses pour la version particulière, l'écriture des articles de données de la version particulière étant effectuée aux adresses lorsque ces adresses sont disponibles pendant la lecture des articles de données à partir de l'autre mémoire pendant une version immédiatement précédente du cycle de base ;
- la génération d'autres ordres d'écriture et de lecture d'adresses, l'autre ordre de lecture d'adresses dans la version particulière du cycle de base étant permuté par rapport à l'autre ordre de lecture d'adresses utilisé dans une version immédiatement précédente du cycle de base selon l'inverse de la fonction pseudo aléatoire, l'inverse de la fonction pseudo aléatoire étant particulier à la version du cycle de base,

dans lequel l'autre ordre de lecture et d'écriture d'adresses est répété périodiquement, chaque autre ordre de lecture d'adresses se répétant chaque fois après une période d'exactement deux versions du cycle de base, l'autre ordre de lecture d'adresses étant alternativement un ordre croissant ou décroissant de façon monotone d'adresses et un autre ordre dans lequel les adresses pour la lecture sont permutées selon l'inverse de la fonction pseudo aléatoire.

7. Système pour la transmission et la réception de données protégées contre les erreurs, le système comportant:

- une section de transmission pour coder des articles de données selon un code de correction d'erreurs de convolution et par conséquent entrelacer de façon pseudo aléatoire les articles de données, les articles de données étant transmis modulés dans un nombre de canaux de fréquence simultanément actifs et transmis par l'intermédiaire d'un canal de transmission ;
- une section de réception pour recevoir, désentrelacer et décoder les articles de données transmis selon le code de correction d'erreurs de convolution,

**caractérisé en ce que** la section de réception comporte une mémoire, le désentrelacement dans la section de réception comportant l'écriture des articles de données reçus dans des emplacements dans la mémoire dans un ordre d'écriture et de lecture des articles de données dans un ordre désentrelacé de lecture, le désentrelacement étant effectué dans des versions successives d'un cycle de base, les articles de données pour une version du cycle de base étant écrits dans les emplacements lorsque les emplacements sont disponibles lors de la lecture pour une version immédiatement précédente du cycle de base, l'ordre d'écriture des articles de données dans des cycles successifs étant alternativement un ordre d'emplacements avec des adresses croissant ou décroissantes de façon monotone et un ordre avec des adresses permutées selon une fonction pseudo aléatoire, la section de transmission étant agencée pour entrelacer les articles de données de manière à délivrer un inverse du désentrelacement.

8. Système selon la revendication 7, le système comportant :

la section de transmission comportant :

- un codeur (10) pour coder les données dans chaque version du cycle de base dans une succession logique respective d'articles de données dans un code de correction d'erreurs de convolution qui est plus robuste contre les erreurs qui sont distinctes les unes des autres que contre les erreurs qui se produisent en rafale dans la succession logique respective ;
- un générateur de signaux (14) pour générer un signal comportant un nombre de canaux de fréquence, les articles de données pour une version du cycle de base étant modulés dans ceux respectifs des canaux de fréquence qui sont simultanément actifs ;
- un moyen de sélection (12) pour sélectionner pour chaque article de données particulier un canal de fréquence particulier selon une position particulière de l'article de données dans sa succession logique ;
- un modulateur (14) pour moduler chaque canal de fréquence du signal selon au moins l'un respectif des articles de données, l'article de données particulier étant modulé dans le canal de fréquence particulier ;
- un transmetteur pour transmettre le signal par l'intermédiaire du canal de transmission ;

une section de réception comportant :

- une entrée de réception pour recevoir le signal depuis le canal de transmission ;
- un démodulateur (16) pour démoduler les articles de données à partir des canaux de fréquence du signal ;
- un moyen de sélection inverse (18, 52, 54, 56) pour sélectionner la position logique de l'article de données particulier dans sa succession logique respective, selon le canal de fréquence particulier à partir duquel l'article de données particulier a été démodulé ;
- un décodeur pour décoder les articles de données reçus selon le code de correction d'erreurs de convolution appliqué à la séquence logique telle qu'obtenue par le moyen de sélection inverse (18, 52, 54, 56) ;

**caractérisé en ce que** le moyen de sélection inverse (18, 52, 54, 56) comporte :

- une mémoire ;
- un moyen d'écriture pour écrire, lors de la réception depuis le démodulateur (16), l'article de données à partir de chaque version particulière du cycle de base dans la mémoire dans un ordre d'écriture d'adresses pour la version particulière ;

- un moyen de lecture pour lire les articles de données pour cette version particulière à partir de la mémoire dans un ordre de lecture d'adresses pour la version particulière, permuté selon une fonction pseudo aléatoire par rapport à l'ordre d'écriture d'adresses pour la version particulière, le moyen d'écriture écrivant les articles de données de la version particulière aux adresses lorsque ces adresses sont disponibles pendant la lecture des articles de données d'une version immédiatement précédente du cycle de base ;

- un moyen de génération d'adresses (52, 54) pour générer les ordres d'écriture et de lecture d'adresses, l'ordre de lecture d'adresses dans la version particulière du cycle de base étant permuté par rapport à l'ordre de lecture d'adresses utilisé dans une version immédiatement précédente du cycle de base selon la fonction pseudo aléatoire, la fonction pseudo aléatoire étant particulière à la version du cycle de base ; le moyen de génération d'adresses générant périodiquement l'ordre de lecture et d'écriture d'adresses, chaque ordre de lecture d'adresses se répétant chaque fois après une période d'exactement deux versions du cycle de base, l'ordre de lecture d'adresses étant alternativement un ordre croissant ou décroissant de façon monotone d'adresses et un ordre dans lequel les adresses pour la lecture sont permutées selon la fonction pseudo aléatoire ;

le moyen de sélection (12) de la section de transmission sélectionnant le canal de fréquence particulier pour des positions dans chaque succession logique respective de manière à délivrer un inverse de l'affectation des articles de données depuis les canaux de fréquence en des positions dans la succession logique respective effectuée par le moyen de sélection inverse (18, 52, 54, 56) de la section de réception.

9. Système de transmission selon la revendication 8, dans lequel les adresses des emplacements de mémoire sont calculées selon une séquence congruente linéaire satisfaisant

$$X_{n+1} = (aX_n + c) \bmod M$$

n étant la position d'un article de données particulier dans l'ordre de lecture d'adresses, $X_n$ étant l'adresse à partir de laquelle cet article de données particulier est lu, M étant le nombre d'emplacements de mémoire pouvant être sélectionné, a et c étant un facteur et un opérande de somme pour une séquence congruente linéaire respectivement, la combinaison du facteur et de l'opérande de somme étant changée pour chaque version du cycle de base.

10. Dispositif de réception pour un système de transmission et de réception de données protégées contre les erreurs, le dispositif de réception étant agencé pour recevoir, désentrelacer et décoder les articles de données transmis selon un code de correction d'erreurs de convolution, **caractérisé en ce que** le dispositif de réception comporte une mémoire, le désentrelacement dans la section de réception comportant l'écriture des articles de données reçus dans des emplacements dans la mémoire dans l'ordre d'écriture et de lecture des articles de données dans un ordre désentrelacé de lecture, le désentrelacement étant effectué dans des versions successives d'un cycle de base, les articles de données pour une version du cycle de base étant écrits dans des emplacements lorsque les emplacements sont disponibles à la lecture pour une version immédiatement précédente du cycle de base, l'ordre d'écriture des articles de données dans des cycles successifs étant alternativement un ordre d'emplacements avec des adresses croissant et décroissantes de façon monotone et un ordre avec des adresses permutées selon une fonction pseudo aléatoire.

11. Dispositif de transmission pour un système de transmission et de réception de données protégées contre les erreurs, le dispositif de transmission étant agencé pour coder les articles de données selon un code de correction d'erreurs de convolution et par conséquent entrelacer de façon pseudo aléatoire les articles de données, les articles de données étant transmis modulés dans un nombre de canaux de fréquence simultanément actifs et transmis par l'intermédiaire d'un canal de transmission, **caractérisé en ce que** le dispositif de transmission est agencé pour entrelacer les articles de données de manière à délivrer un inverse d'un désentrelacement qui comporte l'écriture des articles de données reçus dans des emplacements dans une mémoire dans l'ordre d'écriture et de lecture des articles de données dans un ordre désentrelacé de lecture, le désentrelacement étant effectué dans des versions successives d'un cycle de base, les articles de données pour une version du cycle de base étant écrits dans les emplacements lorsque les emplacements sont disponibles lors de la lecture pour une version immédiatement précédente du cycle de base, l'ordre d'écriture des articles de données dans des cycles successifs étant alternativement un ordre d'emplacements avec des adresses croissant ou décroissantes de façon monotone et un ordre avec des adresses permutées selon une fonction pseudo aléatoire.

12. Dispositif de transmission selon la revendication 11, le moyen de sélection (12) dans le dispositif de transmission comportant :

- un moyen d'écriture pour écrire les articles de données à partir de chaque succession logique dans une autre mémoire dans un autre ordre d'écriture d'adresses pour la version particulière du cycle de base ;
- un moyen de lecture pour lire les articles de données pour cette version particulière à partir de l'autre mémoire dans un autre ordre de lecture d'adresses pour la version particulière, permuté selon un inverse de la fonction pseudo aléatoire par rapport à l'autre ordre d'écriture d'adresses pour la version particulière, l'écriture des articles de données de la version particulière étant effectuée à des adresses lorsque ces adresses sont disponibles lors de la lecture des articles de données à partir de l'autre mémoire pendant une version immédiatement précédente du cycle de base ;
- un moyen de génération (52, 54) pour générer les autres ordres d'écriture et de lecture d'adresses, l'autre ordre de lecture d'adresses dans la version particulière du cycle de base étant permuté par rapport à l'autre ordre de lecture d'adresses utilisé dans une version immédiatement précédente du cycle de base selon l'inverse de la fonction pseudo aléatoire, l'inverse de la fonction pseudo aléatoire étant particulier à la version du cycle de base, dans lequel l'autre ordre de lecture et d'écriture d'adresses est répété périodiquement, chaque autre ordre de lecture d'adresses se répétant chaque fois après une période d'exactement deux versions du cycle de base, l'autre ordre de lecture d'adresses étant alternativement un ordre croissant ou décroissant de façon monotone d'adresses et un autre ordre dans lequel les adresses de lecture sont permutées selon l'inverse de la fonction pseudo aléatoire.

FIG. 1

FIG. 2

52

50

54

58

memory 56

**FIG. 3**

60

54

62 X

63

64 +

65

**FIG. 4**

75

76

70

71

74

72

78

**FIG. 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5151976 A

- EP 370444 A

### Non-patent literature cited in the description

- **G.C. Clark ; J.B. Cain.** Error correction coding for digital communications. Plenum Press, 1981